# EUROPEAN PATENT SPECIFICATION

(11) **EP 2 025 458 B1**
(45) Date of publication and mention of the grant of the patent: **03.06.2015**
(21) Application number: 08162352.2
(22) Date of filing: 14.08.2008
(51) Int. Cl.: B24B 7/22, B24B 37/04, B24D 13/14, B24D 11/00

(54) **Interpenetrating network for chemical mechanical polishing**
Durchdringendes Netzwerk für chemisch-mechanisches Polieren
Interpénétration de réseau pour polissage mécanique et chimique

(30) Priority: 15.08.2007 US 839376
(43) Date of publication of application: 18.02.2009
(73) Proprietor: Rohm and Haas Electronic Materials CMP Holdings, Inc., Newark, DE 19713 (US)
(72) Inventor: Muldowney, Gregory P., Earleville, MD 21919 (US)
(74) Representative: Kent, Venetia Katherine

(56) References cited:
- US-A1- 2004 101 680
- US-A1- 2004 259 479
- US-B1- 6 802 878
- US-B1- 7 059 950

## Description

The present invention relates generally to the field of polishing pads for chemical mechanical polishing. In particular, the present invention is directed to a chemical mechanical polishing pad having a polishing structure useful for chemical mechanical polishing magnetic, optical and semiconductor substrates.

In the fabrication of integrated circuits and other electronic devices, multiple layers of conducting, semiconducting and dielectric materials are deposited onto and removed from a surface of a semiconductor wafer. Thin layers of conducting, semiconducting and dielectric materials may be deposited using a number of deposition techniques. Common deposition techniques in modem wafer processing include physical vapor deposition (PVD), also known as sputtering, chemical vapor deposition (CVD), plasma-enhanced chemical vapor deposition (PECVD) and electrochemical plating, among others. Common removal techniques include wet and dry isotropic and anisotropic etching, among others.

As layers of materials are sequentially deposited and removed, the uppermost surface of the wafer becomes non-planar. Because subsequent semiconductor processing (e.g., metallization) requires the wafer to have a flat surface, the wafer needs to be planarized. Planarization is useful for removing undesired surface topography and surface defects, such as rough surfaces, agglomerated materials, crystal lattice damage, scratches and contaminated layers or materials.

Chemical mechanical planarization, or chemical mechanical polishing (CMP), is a common technique used to planarize or polish workpieces such as semiconductor wafers. In conventional CMP, a wafer carrier, or polishing head, is mounted on a carrier assembly. The polishing head holds the wafer and positions the wafer in contact with a polishing layer of a polishing pad that is mounted on a table or platen within a CMP apparatus. The carrier assembly provides a controllable pressure between the wafer and polishing pad. Simultaneously, a slurry or other polishing medium is dispensed onto the polishing pad and is drawn into the gap between the wafer and polishing layer. To effect polishing, the polishing pad and wafer typically rotate relative to one another. As the polishing pad rotates beneath the wafer, the wafer sweeps out a typically annular polishing track, or polishing region, wherein the wafer's surface directly confronts the polishing layer. The wafer surface is polished and made planar by chemical and mechanical action of the polishing layer and polishing medium on the surface.

US-A-2004/259479 discloses an electrochemical-mechanical polishing pad for polishing a semiconductor wafer, the polishing pad comprising a top surface comprising a first set of grooves and a bottom surface comprising a second second set of grooves, wherein the first and second set of grooves are interconnected and not aligned.

The interaction among polishing layers, polishing media and wafer surfaces during CMP has been the subject of increasing study, analysis, and advanced numerical modeling in the past ten years in an effort to optimize polishing pad designs. Most of the polishing pad developments since the inception of CMP as a semiconductor manufacturing process have been empirical in nature, involving trials of many different porous and non-porous polymeric materials. Much of the design of polishing surfaces, or layers, has focused on providing these layers with various microstructures, or patterns of void areas and solid areas, and macrostructures, or arrangements of surface perforations or grooves, that are claimed to increase polishing rate, improve polishing uniformity, or reduce polishing defects (scratches, pits, delaminated regions, and other surface or sub-surface damage). Over the years, quite a few different microstructures and macrostructures have been proposed to enhance CMP performance.

For conventional polishing pads, pad surface "conditioning" or "dressing" is critical to maintaining a consistent polishing surface for stable polishing performance. Over time the polishing surface of the polishing pad wears down, smoothing over the microtexture of the polishing surface-a phenomenon called "glazing". The origin of glazing is plastic flow of the polymeric material due to frictional heating and shear at the points of contact between the pad and the workpiece. Additionally, debris from the CMP process can clog the surface voids as well as the micro-channels through which slurry flows across the polishing surface. When this occurs, the polishing rate of the CMP process decreases, and this can result in non-uniform polishing between wafers or within a wafer. Conditioning creates a new texture on the polishing surface useful for maintaining the desired polishing rate and uniformity in the CMP process.

Conventional polishing pad conditioning is achieved by abrading the polishing surface mechanically with a conditioning disk. The conditioning disk has a rough conditioning surface typically comprised of imbedded diamond points. The conditioning disk is brought into contact with the polishing surface either during intermittent breaks in the CMP process when polishing is paused ("ex situ"), or while the CMP process is underway ("in situ"). Typically the conditioning disk is rotated in a position that is fixed with respect to the axis of rotation of the polishing pad, and sweeps out an annular conditioning region as the polishing pad is rotated. The conditioning process as described cuts microscopic furrows into the pad surface, both abrading and plowing the pad material and renewing the polishing texture.

Although pad designers have produced various microstructures and configurations of surface texture through both pad material preparation and surface conditioning, existing CMP pad polishing textures are less than optimal in two important aspects. First, the actual contact area between a conventional CMP pad and a typical workpiece under the applied pressures practiced in CMP is small-usually only a few percent of the total confronting area. This is a direct consequence of the inexactness of conventional surface conditioning that amounts to randomly tearing the solid regions of the structure into tatters, leaving a population of features, or asperities, of various shapes and heights of which only the tallest actually contact the workpiece. Second, the slurry flow in the thin layer at the pad surface is not optimized for the removal of debris and heat away from the workpiece. Slurry flow between the pad and workpiece must pass across the highly irregular surface and around any asperities that bridge the full vertical distance from the pad to the workpiece. This results in a high probability that the workpiece is re-exposed to both spent chemistry and material previously removed. Thus conventional pad microstructures are not optimal because contact mechanics and fluid mechanics within the surface texture are coupled: the height distribution of asperities favors neither good contact nor effective fluid flow and transport.

Defect formation in CMP has origins in both shortcomings of conventional pad microstructure. For example, Reinhardt et al., in US Pat. No. 5,578,362, disclose the use of polymeric spheres to introduce texture into a polyurethane polishing pad. Although exact defect formation mechanisms are incompletely understood, it is generally clear that reducing defect formation requires minimizing extreme point stresses on the workpiece. Under a given applied load or polish pressure, the actual point contact pressure is inversely proportional to the true contact area. A CMP process running at 3 psi (20.7 kPa) polish pressure and having 2% real contact area across all asperity tips actually subjects the workpiece to normal stresses averaging 150 psi (1 MPa). Stresses of this magnitude are sufficient to cause surface and sub-surface damage. Being blunt and irregular in shape, asperities on conventional CMP pads also lead to unfavorable flow patterns: localized pressures of fluid impinging on asperities can be significant, and regions of stagnant or separated flow can lead to accumulation of polish debris and heat or create an environment for particle agglomeration.

Beyond providing potential defect formation sources, conventional polishing pad microtexture is not optimal because pad surface conditioning is typically not exactly reproducible. The diamonds on a conditioning disk become dulled with use such that the conditioner must be replaced after a period of time; during its life the effectiveness of the conditioner thus continually changes. Conditioning also contributes greatly to the wear rate of a CMP pad. It is common for about 95% of the wear of a pad to result from the abrasion of the diamond conditioner and only about 5% from contact with workpieces. Thus in addition to defect reduction, improved pad microstructure could eliminate the need for conditioning and allow longer pad life.

The key to eliminating pad conditioning is to devise a polishing surface that is self-renewing, that is, that retains the same essential geometry and configuration as it wears. Thus to be self-renewing, the polishing surface must be such that wear does not significantly reshape the solid regions. This in turn requires that the solid regions not be subjected to continuous shear and heating sufficient to cause a substantial degree of plastic flow, or that the solid regions be configured so that they respond to shear or heating in a way that distributes the shear and heating to other solid regions.

In addition to low defectivity, CMP pad polishing structures must achieve good planarization efficiency. Conventional pad materials require a trade-off between these two performance metrics because lower defectivity is achieved by making the material softer and more compliant, yet these same property changes compromise planarization efficiency. Ultimately, planarization requires a stiff flat material; while low defectivity requires a less stiff conformal material. It is thus difficult to surmount the essential trade-off between these metrics with a single material. Conventional pad structures approach this problem in a variety of ways, including the use of composite materials having hard and soft layers bonded to one another. While composites offer improvements over single-layer structures, no material has yet been developed that achieves ideal planarization efficiency and zero defect formation simultaneously.

Consequently, while pad microstructure and conditioning means exist for contemporary CMP applications, there is a need for CMP pad designs that achieve higher real contact area with the workpiece and more effective slurry flow patterns for removal of polish debris, as well as reducing or eliminating the need for re-texturing. In addition, there is a need for CMP pad structures that combine a rigid stiff structure needed for good planarization efficiency with a less stiff conformal structure needed for low defectivity. Also, there is a need for CMP pad structures that provide a high void volume in the polishing layer proximate the polishing surface to facilitate good slurry access to individual contact points with the workpiece, but which do not present a large void volume within the polishing layer distant from the polishing surface (which void volume might support the accumulation of stagnant slurry and polishing waste).

The present invention, in its various aspects, is as set out in the accompanying claims.

In one aspect of the present invention, there is provided a chemical mechanical polishing pad for polishing a substrate selected from at least one of a magnetic substrate, an optical substrate and a semiconductor substrate; comprising: a polishing layer comprising an interpenetrating network, wherein the interpenetrating network comprises a continuous non-fugitive phase and a substantially co-continuous fugitive phase; and wherein the polishing layer has a polishing surface adapted for polishing the substrate.

In another aspect of the present invention, there is provided a chemical mechanical polishing pad for polishing a substrate selected from at least one of a magnetic substrate, an optical substrate and a semiconductor substrate; comprising: a polishing layer comprising an interpenetrating network, wherein the interpenetrating network comprises a continuous non-fugitive phase and a substantially co-continuous fugitive phase; wherein the non-fugitive phase forms a three-dimensional network that comprises a plurality of interconnected polishing elements that define a reticulated interstitial area; wherein the substantially co-continuous fugitive phase is disposed within the reticulated interstitial area; and, wherein the polishing surface is adapted for polishing the substrate.

In another aspect of the present invention, there is provided a method for polishing a substrate, comprising: providing a substrate selected from at least one of a magnetic substrate, an optical substrate and a semiconductor substrate; providing a chemical mechanical polishing pad having a polishing layer comprising an interpenetrating network, wherein the interpenetrating network comprises a continuous non-fugitive phase and a substantially co-continuous fugitive phase, wherein the polishing layer has a polishing surface adapted for polishing the substrate; providing a polishing medium at an interface between the polishing surface and the substrate; and, creating dynamic contact at the interface between the chemical mechanical polishing pad and the substrate.

### BRIEF DESCRIPTION OF THE DRAWINGS

**Figure 1** is a perspective view of a portion of a dual-axis polisher suitable for use with the chemical mechanical polishing pads of the present invention.
**Figure 2** is a highly enlarged, partial, schematic, cross-sectional, elevational view of a chemical mechanical polishing pad of one embodiment of the present invention.
**Figure 3** is a highly enlarged, partial, schematic, plan view of the polishing pad of **Figure 2****.**
**Figure 4** is a highly enlarged, partial, schematic, cross-sectional, elevational view of a chemical mechanical polishing pad of one embodiment of the present invention.
**Figure 5** is a highly enlarged, partial, schematic, cross-sectional, elevational, view of a chemical mechanical polishing pad of one embodiment of the present invention.
**Figure 6** is a side perspective view of a chemical mechanical polishing pad of one embodiment of the present invention.
**Figure 7** is a top plan view of a chemical mechanical polishing pad of one embodiment of the present invention depicting a groove pattern in the polishing surface.
**Figure 8** is a top plan view of a chemical mechanical polishing pad of one embodiment of the present invention depicting a groove pattern in the polishing surface.
**Figure 9** is a top plan view of a chemical mechanical polishing pad of one embodiment of the present invention depicting a groove pattern in the polishing surface.
**Figure 10** is a top plan view of a chemical mechanical polishing pad of one embodiment of the present invention depicting a combination of perforations and groove pattern in the polishing surface.
**Figure 11** is a top plan view of a chemical mechanical polishing pad of one embodiment of the present invention depicting a plurality of perforations in the polishing surface.

### DETAILED DESCRIPTION

The term **"chemical bond"** as used herein and in the appended claims refers to attractive forces between atoms and encompasses covalent bonds, ionic bonds, metallic bonds, hydrogen bonds and van der Waals forces.

The term **"fibrillar morphology"** as used herein and in the appended claims refers to a morphology of a phase in which the phase domains have a three dimensional shape with one dimension much larger than the other two dimensions.

The term **"fugitive phase"** as used herein and in the appended claims refers to a phase that melts upon exposure to heat generated during polishing.

The term **"hydrodynamic layer"** as used herein and in the appended claims refers to a region of a polishing layer proximate the polishing surface which is **substantially free** of the co-continuous fugitive phase.

The term **"interpenetrating network"** as used herein and in the appended claims refers to a network comprising a continuous non-fugitive phase and a substantially co-continuous fugitive phase, wherein the fugitive phase (a) is not covalently bound to non-fugitive phase and (b) cannot be separated from the non-fugitive phase unless chemical bonds are broken within at least one of the phases.

The term **"interpenetrating polymer network"** as used herein and in the appended claims refers to a polymeric network comprising a continuous non-fugitive polymeric phase and a substantially co-continuous fugitive polymeric phase, wherein the fugitive polymeric phase (a) is not covalently bound to the non-fugitive phase and (b) cannot be separated from the non-fugitive phase unless chemical bonds are broken within at least one of the phases.

The term **"macrotexture"** as used herein and in the appended claims in reference to the polishing surface refers to larger size textured artifacts that may be imposed by embossing, skiving, perforating and/or machining of the polishing surface.

The term **"non-water soluble"** as used herein and in the appended claims encompasses materials that have a solubility in water at 25°C of ≤ 0.1 mmoles/L and which do not disintegrate upon submersion in water for 48 hours.

The term **"polishing medium"** as used herein and in the appended claims encompasses particle-containing polishing solutions and non-particle-containing solutions, such as abrasive-free and reactive-liquid polishing solutions.

The term **"substantially free"** as used herein and in the appended claims means less than 5 vol%.

The term **"substantially circular"** as used herein and in the appended claims in reference to the polishing elements means that the radius, r, of the cross section varies by ≤ 20% for the cross section.

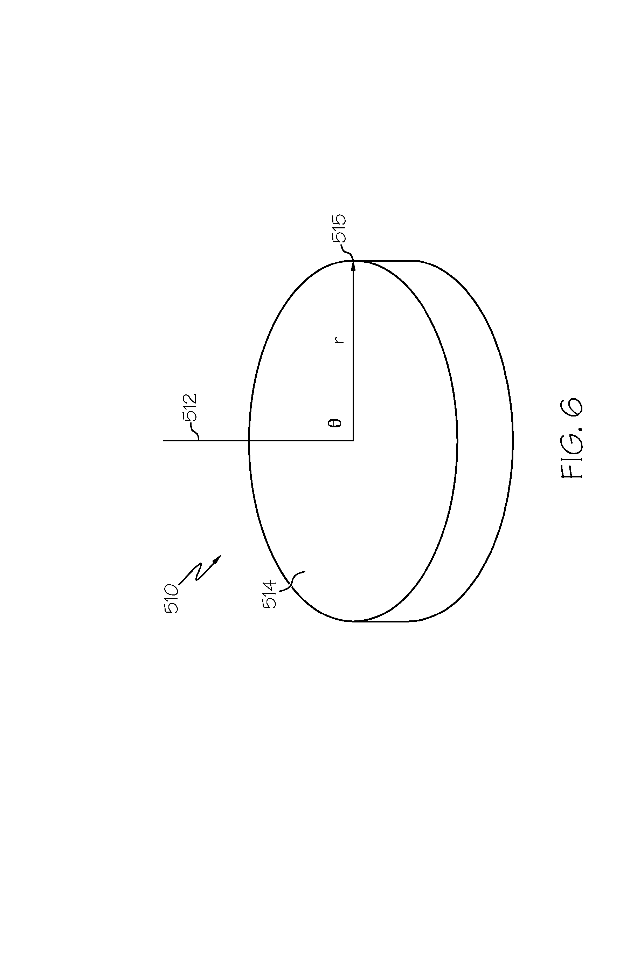

The term **"substantially circular cross section"** as used herein and in the appended claims in reference to the polishing surface means that the radius, r, of the cross section from the central axis to the outer periphery of the polishing surface varies by ≤20% for the cross section. (See **Figure 6**).

The term **"substantially co-continuous"** as used herein and in the appended claims refers to an interpenetrating network in which the fugitive phase is at least 80 wt% continuous.

The term **"water soluble"** as used herein and in the appended claims encompasses materials that **dissolve, dissociate or disintegrate** upon exposure to water.

In some embodiments of the present invention, the chemical mechanical polishing pad comprises: a polishing layer comprising an interpenetrating network, wherein the interpenetrating network comprises a continuous non-fugitive phase and a substantially co-continuous fugitive phase; and wherein the polishing layer has a polishing surface adapted for polishing the substrate. In some aspects of these embodiments, the fugitive phase does not contain abrasive grains (e.g., cerium oxide, manganese oxide, silica, alumina, zirconia). In some aspects of these embodiments, the fugitive phase does not contain a pharmaceutical active. In some aspects of these embodiments, the fugitive phase does not contain an agricultural active (e.g., a fertilizer, insecticide, herbicide). In some aspects of these embodiments, the interpenetrating network is an interpenetrating polymer network.

In some embodiments of the present invention, the chemical mechanical polishing pad comprises: a polishing layer comprising an interpenetrating network, wherein the interpenetrating network comprises a continuous non-fugitive phase and a substantially co-continuous fugitive phase; and wherein the polishing layer has a polishing surface adapted for polishing the substrate. In some aspects of these embodiments, the degree of continuousness of the fugitive phase is determined by solvent extraction methodology. For example, a sample of the polishing layer is submerged in a volume of water sufficiently large to dissolve 100% of the fugitive phase material with a saturation of <80%. The sample is left submerged in the water for 14 days. The sample is then removed from the water and dried. The weight of the sample subsequent to submersion is compared with its weight prior to submersion. A 90% continuous phase would lose 90 wt% of its fugitive phase as a result of the 14 day submersion. In some aspects of these embodiments, the fugitive phase is at least 80 wt% continuous. In some aspects of these embodiments, the fugitive phase is 90 to 100 wt% continuous. In some aspects of these embodiments, the fugitive phase is 95 to 100 wt% continuous. In some aspects of these embodiments, the fugitive phase is 99 to 100 wt% continuous.

Selection of materials for use in the continuous non-fugitive phase is limited by the suitability of those materials for use in a given polishing operation for a substrate made of a particular substance or combination of substances.

In some embodiments of the present invention, the continuous non-fugitive phase comprises at least one of a polymeric material and a non-polymeric material. In some aspects of these embodiments, the continuous non-fugitive phase comprises a composite of a polymeric material and a non-polymeric material.

In some embodiments of the present invention, the continuous non-fugitive phase comprises a polymeric material. In some aspects of these embodiments, the polymeric material comprises a polymer selected from polycarbonates, polysulfones, nylons, polyethers, polyesters, polystyrenes, acrylic polymers, polymethyl methacrylates, polyvinylchlorides, polyvinylfluorides, polyethylenes, polypropylenes, polybutadienes, polyethylene imines, polyurethanes, polyether sulfones, polyamides, polyether imides, polyketones, epoxies, silicones and combinations thereof.

In some embodiments of the present invention, the continuous non-fugitive phase comprises a non-polymeric material. In some aspects of these embodiments, the non-polymeric material comprises a substance selected from ceramic, glass, metal, stone, wood, or a solid phase of a simple material (e.g., ice).

In the present invention, the formulation of the fugitive phase is selected such that the fugitive phase proximate the polishing surface melts upon exposure to an elevated temperature above melting point of at least a portion of the fugitive phase. In some aspects, the fugitive phase proximate the polishing surface melts upon exposure to specific polishing conditions at a rate comparable to the rate at which the non-fugitive phase is worn away during polishing. The fugitive phase formulation is selected such that the heat and dynamic forces generated during polishing in the area of the pad proximate the polishing surface are sufficient to facilitate the melting of the fugitive phase proximate the polishing surface. One of ordinary skill in the art will know how to select the fugitive phase formulation to provide the desired rate of melting for a given polishing operation.

In the present invention, the fugitive phase melts upon exposure to elevated temperatures present during polishing.

In some embodiments of the present invention, the fugitive phase comprises a hydrolizable material. In some aspects of these embodiments, the fugitive phase comprises a material that is soluble in an aqueous medium at a rate of 0.01 to 10.0 mg/min under polishing conditions in which the chemical mechanical polishing pad and the substrate are moving relative to one another at a rate of 1.0 m/sec under a nominal down force of <1 to 5 psi.

In some embodiments of the present invention, the fugitive phase comprises at least one of a water soluble material, a water disintegratable material, and a material that melts at the temperatures present during polishing proximate the polishing surface of the chemical mechanical polishing pad. In some aspects of these embodiments, the fugitive phase comprises at least one of: a polymeric material derived from the polymerization of at least one monomer selected from acrylic acid, methacrylic acid, itaconic acid, fumaric acid, maleic acid, hydroxyalkyl arcylate, hydroxyalkyl methacrylate, N-vinyl-2-pyrrolidone, methylvinyl ether, N-vinyl formamide and N,N-dimethylacryl amide; a polysaccharide (e.g., α, ß and γ-cyclodextrin); a cellulosic material (e.g., hydroxypropyl cellulose, carboxymethyl cellulose, methylcellulose); a protein; a polyvinyl alcohol; a polyethylene oxide; pullulan; a sulfonated polyisoprene; calcium sulfate; sodium silicate; polyethylene glycol solids; paraffin waxes; and, agar starches.

In some embodiments of the present invention, the fugitive phase optionally includes one or more additives to facilitate the controlled rate of dissolution or disintegration of the fugitive phase. In some embodiments of the present invention, the fugitive phase optionally includes one or more surfactants or other materials to facilitate the dissolution of the fugitive phase into the polishing medium.

In some embodiments of the present invention, the chemical mechanical polishing pad comprises a hydrodynamic region proximate to the polishing surface, wherein the hydrodynamic region is substantially free of the fugitive phase. In some aspects of these embodiments, the hydrodynamic region contains ≤ 5 vol% fugitive phase material. In some aspects of these embodiments, the hydrodynamic region contains ≤ 3 vol% fugitive phase material. In some aspects of these embodiments, the hydrodynamic region contains less than ≤ 2 vol% fugitive phase material. In some aspects of these embodiments, the hydrodynamic region contains less than ≤ 1 vol% fugitive phase material.

In some embodiments of the present invention, the polishing layer has a hydrodynamic region that encompasses the polishing surface, wherein the hydrodynamic region is substantially free of the fugitive phase. In some aspects of these embodiments, the hydrodynamic region is bounded on one side by the polishing surface and has an average thickness across the polishing pad of 1 to 100 microns. In some aspects of these embodiments, the hydrodynamic region is bounded on one side by the polishing surface and has an average thickness across the polishing pad of 1 to 50 microns. In some aspects of these embodiments, the hydrodynamic region is bounded on one side by the polishing surface and has an average thickness across the polishing pad of 1 to 25 microns. Is some aspects of these embodiments, the average thickness of the hydrodynamic region remains stable during use of the polishing pad. In some aspects of these embodiments, the average thickness of the hydrodynamic region varies by < 20 % over multiple polishing operations (e.g., after polishing 10 wafers). In some aspects of these embodiments, the average thickness of the hydrodynamic region varies by < 10 % over multiple polishing operations. In some aspects of these embodiments, the average thickness of the hydrodynamic region varies by < 5 % over multiple polishing operations.

If the average thickness of the hydrodynamic region varies significantly over time during polishing (i.e., ≥ 20%), the volume of polishing medium held in the polishing pad may change and the micro flow patterns in the hydrodynamic region may also change. For example, if the average thickness of the hydrodynamic layer shrinks, the volume of polishing medium held in the polishing pad may decrease and the micro flow patterns of the polishing medium in the hydrodynamic region may change over time from polishing operation to polishing operation. Alternatively, if the average thickness of the hydrodynamic region expands over time, the volume of polishing medium held in the chemical mechanical polishing pad may increase, the micro flow patterns of the slurry in the hydrodynamic layer may change, and the volume of essentially stagnant polishing medium held in the chemical mechanical polishing pad will increase over time from polishing operation to polishing operation. Stagnant polishing medium held in the chemical mechanical polishing pad may result in the undesirable accumulation of solid material debris, which solid material may include abrasive from the polishing medium and various waste products from the polishing process. The accumulation of such solid material debris in the chemical mechanical polishing pad may hinder the free flow of slurry within the interstitial openings in the polishing layer. Given the teachings provided in this application, one of ordinary skill in the art will recognize that a chemical mechanical polishing pad of the present invention with a fugitive phase formulation that melts, dissolves, or disintegrates too quickly or too slowly relative to the rate at which the non-fugitive phase wears away, may exhibit non-uniform performance from polishing operation to polishing operation (e.g., from wafer to wafer) over the life of the polishing pad. Accordingly, given the teachings of this application, one of ordinary skill in the art will recognize that a chemical mechanical polishing pad of the present invention with a fugitive phase formulation that melts, dissolves or disintegrates too quickly or too slowly will not be optimized from polishing operation to polishing operation (e.g., from wafer to wafer) over the life of the polishing pad.

In some embodiments of the present invention, the co-continuous fugitive phase is water soluble.

In some embodiments of the present invention, the continuous non-fugitive phase is non-water soluble and the co-continuous fugitive phase is water soluble.

In the present invention, the co-continuous fugitive phase melts upon exposure to heat generated during polishing.

In some embodiments of the present invention, the continuous non-fugitive phase forms a reticulated network. In some aspects of these embodiments, at least a portion of the interstitial void volume within the reticulated network formed by the continuous non-fugitive phase is occupied by the co-continuous fugitive phase. In some aspects of these embodiments, at least 50 vol% of the interstitial void volume within the reticulated network is occupied by the co-continuous fugitive phase. In some aspects of these embodiments, at least 75 vol% of the interstitial void volume within the reticulated network is occupied by the co-continuous fugitive phase. In some aspects of these embodiments, at least 90 vol% of the interstitial void volume within the reticulated network is occupied by the co-continuous fugitive phase. In some aspects of these embodiments, 50 vol% to 100 vol% of the interstitial void volume within the reticulated network is occupied by the co-continuous fugitive phase. In some aspects of these embodiments, 50 to 99 vol% of the interstitial void volume within the reticulated network is occupied by the co-continuous fugitive phase. In some aspects of these embodiments, 75 to 99 vol% of the interstitial void volume within the reticulated network is occupied by the co-continuous fugitive phase. In some aspects of these embodiments, the continuous non-fugitive phase has a fibrillar morphology. In some aspects of these embodiments, the continuous non-fugitive phase has a double gyroid morphology. In some aspects of these embodiments, the continuous non-fugitive phase forms an interconnected network of structural members.

In some embodiments of the present invention, the continuous non-fugitive phase has a fibrillar morphology composed of a multiplicity of polishing elements, wherein a cross-sectional area of each polishing element along a long dimension thereof varies by <= 30% across the long dimension. In some aspects of these embodiments, the cross-sectional area varies by <= 25%; preferably <= 20%; more preferably <= 10% across the long dimension. In some aspects of these embodiments, the cross-sectional area of each polishing element along a long dimension thereof is substantially circular. In some aspects of these embodiments, the cross-sectional area of each polishing element along a long dimension thereof is streamlined with respect to fluid flow in a plane of the cross-sectional area.

In some embodiments of the present invention, the polishing layer comprises 0.5 to 80 vol% continuous non-fugitive phase material. In some aspects of these embodiments, the polishing layer comprises ≥1 vol% to ≤ 50 vol% continuous non-fugitive phase material.

In some embodiments of the present invention, the polishing layer has an average thickness of 20 to 150 mils. In some aspects of these embodiments, the polishing layer has an average thickness of 30 to 125 mils. In some aspects of these embodiments, the polishing layer has an average thickness of 40 to 120 mils.

In some embodiments of the present invention, the chemical mechanical polishing pad has a polishing surface with a surface area measured in a plane parallel to the polishing surface that changes by ≤ 10% over multiple polishing operations (i.e., after polishing 10 wafers). In some aspects of these embodiments, the polishing area changes by ≤ 5%; more preferably ≤ 2 %; still more preferably ≤ 1%.

In some embodiments of the present invention, the chemical mechanical polishing pad comprises a polishing layer interfaced with a base layer. In some aspects of these embodiments, the polishing layer is attached to the base layer using an adhesive. In some aspects of these embodiments, the adhesive is selected from pressure sensitive adhesives, hot melt adhesives, contact adhesives and combinations thereof. In some aspects of these embodiments, the adhesive is a hot melt adhesive. In some aspects of these embodiments, the adhesive is a contact adhesive. In some aspects of these embodiments, the adhesive is a pressure sensitive adhesive.

In some embodiments of the present invention, the chemical mechanical polishing pad comprises a polishing layer, a base layer and at least one additional layer interposed between the base layer and the polishing layer.

In some embodiments of the present invention, the chemical mechanical polishing pad has a polishing surface that optionally exhibits macrotexture to facilitate polishing the substrate. In some aspects of these embodiments, the macrotexture is designed to alleviate at least one of hydroplaning; to influence polishing medium flow; to modify the stiffness of the polishing layer; to reduce edge effects; and, to facilitate the transfer of polishing debris away from the area between the polishing surface and the substrate. In some aspects of these embodiments, the polishing surface exhibits macrotexture selected from at least one of perforations and grooves. In some aspects of these embodiments, the perforations can extend from the polishing surface part way or all of the way through the thickness of the polishing layer. In some aspects of these embodiments, the grooves are arranged on the polishing surface such that upon rotation of the pad during polishing, at least one groove sweeps over the substrate. In some aspects of these embodiments, the grooves are selected from curved grooves, linear grooves and combinations thereof.

In some embodiments of the present invention, the polishing layer optionally exhibits a macrotexture comprising a groove pattern. In some aspects of these embodiments, the groove pattern comprises at least one groove. In some aspects of these embodiments, the groove pattern comprises a plurality of grooves. In some aspects of these embodiments, the at least one groove is selected from curved grooves, straight grooves and combinations thereof. In some aspects of these embodiments, the groove pattern is selected from a groove design including, for example, concentric grooves, curved grooves, cross-hatch grooves (e.g., arranged as an X-Y grid across the pad surface), other regular designs (e.g., hexagons, triangles), tire-tread type patterns, irregular designs (e.g., fractal patterns), and combinations thereof. In some aspects of these embodiments, the groove pattern is selected from random, concentric, spiral, cross-hatched, X-Y grid, hexagonal, triangular, fractal and combinations thereof. In some aspects of these embodiments, the groove profile is selected from rectangular with straight side-walls or the groove cross-section may be "V"-shaped, "U"-shaped, triangular, rhomboid, saw-tooth, and combinations thereof. In some aspects of these embodiments, the groove pattern is a groove design that changes across the polishing surface. In some aspects of these embodiments, the groove design is engineered for a specific application. In some aspects of these embodiments, the groove dimensions in a specific design may be varied across the pad surface to produce regions of different groove densities.

In some embodiments of the present invention, the chemical mechanical polishing pad is adapted to be interfaced with a platen of a polishing machine. In some aspects of these embodiments, the chemical mechanical polishing pad is adapted to be affixed to the platen. In some aspects of these embodiments, the chemical mechanical polishing pad is adapted to be affixed to the platen using at least one of a pressure sensitive adhesive and vacuum.

In some embodiments of the present invention, the method for polishing a substrate comprises: providing a substrate selected from at least one of a magnetic substrate, an optical substrate and a semiconductor substrate; providing a chemical mechanical polishing pad having a polishing layer comprising an interpenetrating network, wherein the interpenetrating network comprises a continuous non-fugitive phase and a substantially co-continuous fugitive phase , wherein the polishing layer has a polishing surface adapted for polishing the substrate; providing a polishing medium at an interface between the polishing surface and the substrate; and, creating dynamic contact at the interface between the chemical mechanical polishing pad and the substrate. In some aspects of these embodiments, the method further comprises interfacing the polishing pad with a platen of a polishing machine. In some aspects of these embodiments, the method further comprises conditioning the polishing surface. In some aspects of these embodiments, the co-continuous fugitive phase is 100 wt% continuous. In some aspects of these embodiments, the co-continuous fugitive phase is 80 to 100 wt% continuous. In some aspects of these embodiments, the co-continuous fugitive phase is 90 to 100 wt% continuous. In some aspects of these embodiments, the co-continuous fugitive phase is 95 to 100 wt% continuous. In some aspects of these embodiments, the co-continuous fugitive phase is 99 to 100 wt% continuous. In some aspects of these embodiments, the substrate comprises a series of patterned semiconductor wafers.

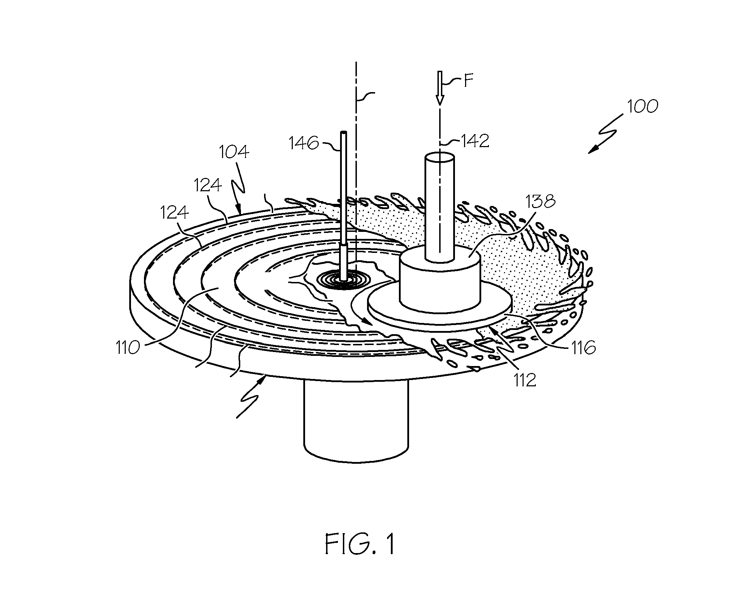

Referring to the drawings, **Figure 1** generally illustrates the primary features of a dual-axis chemical mechanical polishing (CMP) polisher **100** suitable for use with a polishing pad **104** of the present invention. Polishing pad **104** generally includes a polishing layer **108** having a polishing surface **110** for confronting an article, such as semiconductor wafer **112** (processed or unprocessed) or other workpiece, e.g., glass, flat panel display or magnetic information storage disk, among others, so as to effect polishing of the polished surface **116** of the workpiece in the presence of a polishing medium **120.** Polishing medium **120** travels through optional spiral grooves **124** having a depth **128.**

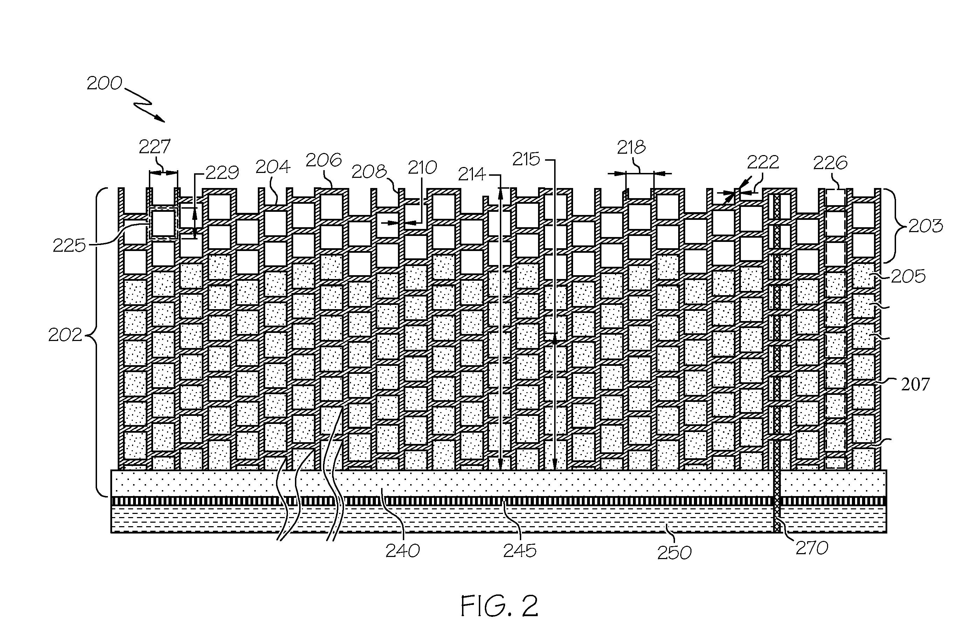

The present invention generally includes providing polishing layer **108** with a polishing texture **200** (**Figure 2**) having a high void fraction or percentage of open volume versus solid volume in a hydrodynamic region **203** thereof, by forming polishing layer **108** from a continuous non-fugitive phase material **207** comprised of a series of similar or identical macroscopic or microscopic slender elements, each element constrained at one or more ends, such that the total space occupied by these elements is small relative to the total space available, the spacing of individual elements is small relative to the size of the wafer, and the elements are interconnected in three dimensions to stiffen the network with respect to shear and bending. Preferably, the elements have microscopic dimensions to create a microtexture. These features will be shown to provide both higher real contact area between the pad and wafer and more favorable slurry flow patterns in the hydrodynamic region **203,** which is not occupied by a co-continuous fugitive phase material **205,** between the pad and wafer than are realized using conventional polishing pads, as well as providing a self-renewing structure that reduces or eliminates the need for pad conditioning. In addition, these features will be shown to function in a way that imparts stiffness to the pad at the length scale required for good planarization efficiency while allowing compliance at the shorter length scales required for low defectivity.

Polisher **100** may include polishing pad **104** mounted on platen **130.** Platen **130** is rotatable about a rotational axis **134** by a platen driver (not shown). Wafer **112** may be supported by a wafer carrier **138** that is rotatable about a rotational axis **142** parallel to, and spaced from, rotational axis **134** of platen **130.** Wafer carrier **138** may feature a gimbaled linkage (not shown) that allows wafer **112** to assume an aspect very slightly non-parallel to polishing layer **108,** in which case rotational axes **134, 142** may be very slightly askew. Wafer **112** includes polished surface **116** that faces polishing layer **108** and is planarized during polishing. Wafer carrier **138** may be supported by a carrier support assembly (not shown) adapted to rotate wafer **112** and provide a downward pressure **F** to press polished surface **116** against polishing layer **108** so that a desired pressure exists between the polished surface and the polishing layer during polishing. Polisher **100** may also include a polishing medium dispenser **146** for supplying polishing medium **120** to polishing layer **108.**

As those ordinarily skilled in the art will appreciate, polisher **100** may include other components (not shown) such as a system controller, polishing medium storage and dispensing system, heating system, rinsing system and various controls for controlling various aspects of the polishing process, such as follows: (1) speed controllers and selectors for one or both of the rotational rates of wafer **112** and polishing pad **104;** (2) controllers and selectors for varying the rate and location of delivery of polishing medium **120** to the pad; (3) controllers and selectors for controlling the pressure **F** applied between the wafer and polishing pad, and (4) controllers, actuators and selectors for controlling the location of rotational axis **142** of the wafer relative to rotational axis **134** of the pad, among others. Those skilled in the art will understand how these components are constructed and implemented such that a detailed explanation of them is not necessary for those skilled in the art to understand and practice the present invention.

During polishing, polishing pad **104** and wafer **112** are rotated about their respective rotational axes **134, 142** and polishing medium **120** is dispensed from polishing medium dispenser **146** onto the rotating polishing pad. Polishing medium **120** spreads out over polishing layer **108,** including the gap beneath wafer **112** and polishing pad **104.** Polishing pad **104** and wafer **112** are typically, but not necessarily, rotated at selected speeds of 0.1 rpm to 150 rpm. Pressure **F** is typically, but not necessarily, selected from a pressure of 0.1 psi to 15 psi (6.9 to 103 kPa) between wafer **112** and polishing pad **104.** As those of ordinary skill in the art will recognize, it is possible to configure the polishing pad in a web format or into polishing pads having a diameter less than the diameter of the substrate being polished.

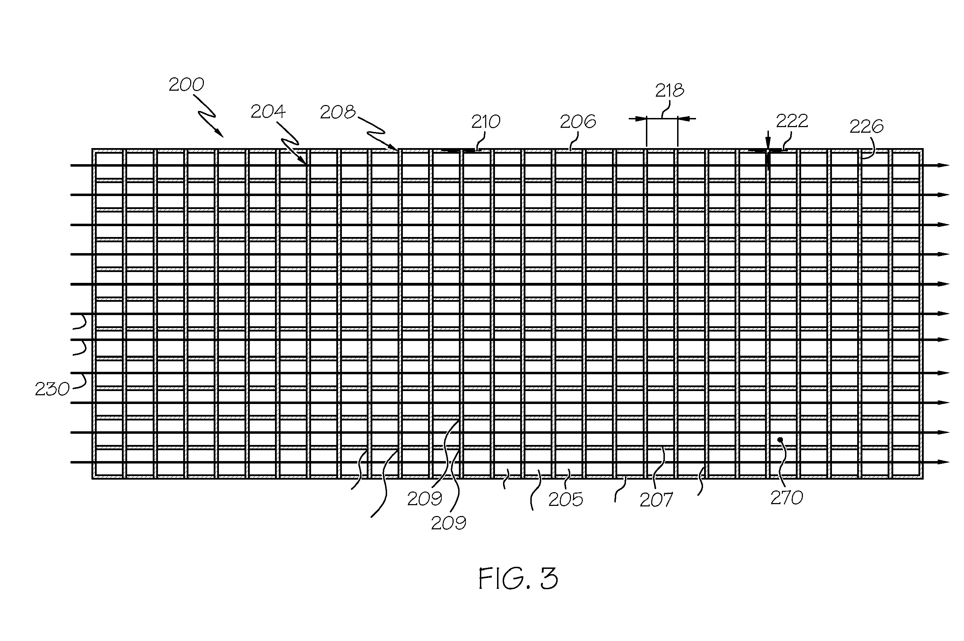

Referring now to **Figures 2** **and** **3****,** embodiments of polishing pad **104** of **Figure 1** will be described in more detail, in particular relative to surface polishing texture **200.** In contrast to conventional CMP pads in which surface texture or asperities are the residue of a material removal or reshaping process (i.e. conditioning), polishing texture **200** is built as a series of identical or similar polishing elements **204** and **208** having a precise geometry. For purposes of illustration, polishing texture **200** is shown to consist of substantially vertical elements **208** and substantially horizontal elements **204,** but this need not be the case. Polishing texture **200** is tantamount to a multitude of such polishing elements **204** and **208** each having a mean width **210** and a mean cross-sectional area **222,** the elements being spaced at a mean pitch **218.** As used here and throughout, the term "mean" designates the arithmetic average taken over the entire volume of the element or structure. In addition, the interconnected network of elements **204, 208** has a mean height **214** and mean half-height **215.** The polishing texture **200** is in effect a set of hexahedral unit cells, that is spatial units in which each face (of six) is a square or rectangle and solid members run along the edges only of the spatial unit, leaving the center of each face and of the spatial unit as a whole empty.

The mean height **214** to mean width **210** ratio of elements **208** is at least 0.5. Preferably the mean height **214** to mean width **210** ratio is at least 0.75 and most preferably at least 1. Optionally, the mean height **214** to mean width **210** ratio may be at least 5 or at least 10. As the mean height increases, the number of interconnecting elements **204** required to stiffen the network of polishing elements **208** during polishing increases. In general, only the unconstrained ends of elements **208** projecting beyond the uppermost interconnecting elements **204** are free to flex under shear forces during polishing. The heights of elements **208** between the base layer **240** and the uppermost interconnecting element **204** are highly constrained and forces applied to any one element **208** are effectively carried by many adjacent elements **204** and **208,** similar to a bridge truss or external buttressing. In this way polishing texture **200** is rigid at the length scale required for good planarization, but is locally compliant at shorter length scales by virtue of the local deformability and flexibility of the unbuttressed ends of elements **208.**

The interconnecting elements **204** and polishing elements **208** combine to form a unit cell **225,** the unit cell having a mean width **227** and a mean length **229.** These unit cells have a reticulated or open-cell structure that combine to form the three-dimensional network. In some embodiments of the present invention, the interconnect unit cells have a height of at least three unit cells and preferably at least 10 unit cells. Generally, increasing the height of the polishing pad increases the life of the polishing pad as well as its bulk stiffness, the latter contributing to improved planarization. Optionally, the unit cell's mean width **227** does not equal its mean length **229.** For example a mean width to mean length ratio may be of at least 2 or of at least 4 to further improve polishing performance for some polishing applications. For example, unit cells with an extended horizontal length will tend to provide stiffer polishing elements for improved planarization; and unit cells with extended vertical length will tend to have more flexible polishing members for improved defectivity performance.

An advantage of the high mean height to mean width ratio of elements **208** is that the total polishing surface area of cross-sectional area **222** remains constant for an extended period. As shown in **Figure 2****,** at any point in the life of polishing layer **202,** while most of the contacting area of polishing texture **200** consists of the cross-sections **222** of upright elements **208,** all or part of some interconnecting elements **204** will also be in the process of wearing down, and these are designated in particular as contact elements **206.** Preferably, the vertical positions of interconnecting elements **204** are staggered such that wear occurring parallel to the base layer **240** encounters only a small fraction of interconnecting elements **204** at a given point in time, and these contact elements **206** constitute a small fraction of the total contacting area. This allows polishing of several substrates with similar polishing characteristics and reduces or eliminates the need to periodically dress or condition the pad. This reduction in conditioning extends the pad's life and lowers its operating cost. Furthermore, perforations through the pad, the introduction of conductive-lined grooves or the incorporation of a conductor, such as conductive fibers, conductive network, metal grid or metal wire, can transform the pads into eCMP ("electrochemical mechanical planarization") polishing pads. These pads' three-dimensional network structure may facilitate polishing medium flow in the hydrodynamic region **203** and maintain a consistent surface structure for demanding eCMP applications. It is believed that an increase in polishing medium flow in the hydrodynamic region **203** may improve the removal of spent electrolyte from the eCMP process that may improve uniformity of the eCMP process.

Preferably, substantially no co-continuous fugitive phase material **205** exists within the hydrodynamic region **203** of polishing texture **200.** That is, the only solid material in the hydrodynamic region **203** is the continuous non-fugitive phase material **207** of which polishing elements **204** and **208** are comprised. Optionally, it is possible to secure abrasive particles or fibers to polishing elements **204** and **208.** Correspondingly, no void volume exists within any individual element **204** or **208;** all void volume in polishing texture **200** preferably exists between and distinctly outside polishing elements **204** and **208.** Optionally, however, polishing elements **204** and **208** may have a hollow or porous structure. Polishing elements **208** are rigidly affixed at one end to a base layer **240** that maintains the pitch **218** and maintains polishing elements **208** in a substantially upright orientation. The orientation of elements **208** is further maintained by interconnecting elements **204** at junctions **209** that connect adjacent polishing elements **204** and **208.** The junctions **209** may include an adhesive or chemical bond to secure elements **204** and **209.** Preferably, junctions **209** represent an interconnection of the same materials and most preferably a seamless interconnection of the same materials.

It is preferred that width **210** and pitch **218** of the polishing elements **208** be uniform, or nearly so, across all polishing elements **208** from end to end between junctions **209,** or uniform across subgroups of polishing elements **208.** For example, preferably polishing elements **208** have a width **210** and pitch **218** that remain within 50% of the average width or pitch, respectively, in the polishing layer **202** between contact member **206** and half height **215.** More preferably, polishing elements **208** have a width **210** and pitch **218** that remain within 20% of the average width or pitch, respectively, in the polishing layer **202** between contact member **206** and half height **215.** Most preferably, polishing elements **208** have a width **210** and pitch **218** that remain within 10% of the average width or pitch, respectively, in the polishing layer **202** between contact member **206** and half height **215.** In particular, maintaining cross-sectional area of polishing elements **204** and **208** between adjacent junctions **209** to within 30% facilitates consistent polishing performance. Preferably, the pad maintains cross sectional area to within 20% and most preferably to within 10% between adjacent junctions **209.** Furthermore, polishing elements **204** and **208** preferably have a linear shape to further facilitate consistent polishing. A direct consequence of these features is that the cross-sectional area **222** of the polishing elements **208** does not vary considerably in the vertical direction. Thus as polishing elements **208** are worn during polishing and the height **214** decreases, there is little change in the area **222** presented to the wafer. This consistency in surface area **222** provides for a uniform polishing texture **200** and allows consistent polishing for repeated polishing operations. For example, the uniform structure allows polishing of multiple patterned wafers without adjusting the tool settings. For purposes of this specification, the polishing surface or texture **200** represents the surface area of polishing elements **204** and **208** measured in a plane parallel to the polishing surface. Preferably the total cross sectional area **222** of polishing elements **208** remains within 25 percent between the initial polishing surface or contact elements **206** and the half-height **215** of the vertical column of unit cells **225.** Most preferably, the total cross sectional area **222** of polishing elements **208** remains within 10 percent between the initial polishing surface and the half-height **215** of the vertical column of unit cells **225.** As noted previously, it is further preferable that the vertical positions of interconnecting elements **204** are staggered to minimize the change in total cross sectional area as the elements wear down.

Optionally, it is possible to arrange polishing elements **208** in spaced groupings of several polishing elements **208**-for example, the polishing elements may comprise circular groupings surrounded by areas free from polishing elements. Within each grouping, it is preferred that interconnecting elements **204** be present to maintain the spacing and effective stiffness of the groupings of elements **208.** In addition, it is possible to adjust the density of the polishing elements **204** or **208** in different regions to fine tune removal rates and polishing or wafer uniformity. Furthermore, it is possible to arrange the polishing elements in a manner that forms open channels in the hydrodynamic region **203,** such as circular channels, X-Y channels, radial channels, curved-radial channels or spiral channels. The introduction of these optional channels may facilitate removal of large debris and may improve polishing or wafer uniformity.

It is preferable that height **214** of polishing elements **208** be uniform across all elements. It is preferred that height **214** remains within 20% of the average height, more preferably, remains within 10% of the average height, and even more preferably, remains within 1% of the average height within polishing texture **200.** Optionally, a cutting device, such as a knife, high-speed rotary blade or laser may periodically cut the polishing elements to a uniform height. Furthermore, the diameter and speed of the cutting blade can optionally cut the polishing elements at an angle to alter the polishing surface. For example cutting polishing elements having a circular cross section at an angle will produce a texture of polishing tips that interact with the substrate. Uniformity of height ensures that all polishing elements **208** of polishing texture **200,** as well as all interconnecting contact elements **206** in the plane of wear, have the potential to contact the workpiece. In fact, because industrial CMP tools have machinery to apply unequal polish pressure at different locations on the wafer, and because the fluid pressure generated under the wafer is sufficient to cause the wafer to depart from a position that is precisely horizontal and parallel to the mean level of the pad, it is possible that some polishing elements **208** do not contact the wafer. However in any regions of polishing pad **104** where contact does occur, it is desired that as many polishing elements **208** as possible be of sufficient height to provide contact. Furthermore, since the unbuttressed ends of polishing elements **208** will typically bend with the dynamic contact mechanics of polishing, an initial polish surface area will typically wear to conform to the bend angle. For example, an initial circular top surface will wear to form an angled top surface and the changes in direction experienced during polishing will create multiple wear patterns.

The dimensions and spacing of polishing elements **204** and **208** are chosen to provide both high contact area **222** between the pad and wafer and adequate open area **226** to enable slurry in the hydrodynamic region **203** to remove polish debris. Typically, the continuous non-fugitive phase **207** (i.e., the polishing elements **204** and **208**) constitutes less than 80 percent of the polishing pad volume measured above the base layer **240.** Preferably the polishing elements **204** and **208** constitute less than 75 percent of the polishing pad volume measured above the base layer **240.** For example, typically elements **204** and **208** will occupy 5 to 75 percent of the polishing pad volume measured above the base layer **240.** Polishing pads designed for high contact area typically occupy 40 to 80 percent of the polishing pad volume measured above the base layer **240.** There is an intrinsic trade-off between these objectives: adding more polishing elements **204** and **208** in the available space of polishing texture **200** augments the total contact area **222** but reduces the open area **226** creating more obstacles to slurry flow **230** in the hydrodynamic region **203** and the removal of polish debris. An essential feature of the present invention is that polishing elements **204** and **208** be sufficiently slender and widely spaced to allow a favorable balancing of contact area and open area in the hydrodynamic region **203.** Polishing elements **208** with rectangular or square cross-sections are advantageous for increasing contact area. Pursuant to this balance, the ratio of the pitch **218** of polishing elements **208** to the width **210** of polishing elements **208** may optionally be at least 2. With these limits, elements **204** and **208** may occupy up to 50 percent of the polishing pad volume measured above the base layer **240,** the contact area **222** of polishing texture **200** may reach 25% (that is, the square of one minus the width/pitch ratio) or greater and the open area **226** is 50% of the available area (that is, one minus the width/pitch ratio) or greater. It is further possible that the ratio of the height **214** to the width **210** of the polishing elements **208** may optionally be at least 4, to maximize the open area **226** in the hydrodynamic region **203** (i.e., area that is not occupied by co-continuous fugitive phase **205** or continuous non-fugitive phase **207**) and to allow polish debris to be conveyed horizontally among the polishing elements **204** and **208** while still providing vertical distance between this conveyed debris and the wafer.

Polishing texture **200** is further optimized by choosing the cross-sectional shape of polishing elements **204** and **208** to be streamlined with respect to slurry flow **230** that occurs predominantly in a horizontal direction relative to the polishing surface in the hydrodynamic region **203.** Streamlining of bodies to achieve minimum fluid drag is a well-established discipline of engineering and forms part of the science routinely applied in the design of aircraft, watercraft, automobiles, projectiles, and other objects that move in or relative to a gas or liquid. The equations of fluid flow governing these latter human-scale objects apply identically at the scale of CMP pad macrostructure or microstructure. In essence streamlining consists in choosing a gradually curved cross-section free of sharp transitions such that an external fluid flow may pass around the cross-section without separating from the surface and forming recirculating eddies that consume fluid energy. Pursuant to this consideration, a circular cross-section **222** is preferred over a square or rectangular cross-section for polishing elements **204** and **208.** Further streamlining of the shapes of polishing elements **208** requires knowledge of the local direction of the slurry flow **230** in the hydrodynamic region **203.** Because both the pad and wafer are rotating, the slurry flow **230** in the hydrodynamic region **203** may approach the polishing elements **204** and **208** from a variety of angles and the correct streamlining for one angle of approach will be sub-optimal for other angles of approach. The only shape that is streamlined equally to all directions of fluid approach is a circular cross-section, thus it is preferred in the general case. If the dominant flow direction can be determined, as in the case of a CMP process having a very high ratio of platen speed to carrier speed, it is more preferred to streamline the cross-section of polishing elements **204** and **208** with respect to that direction.

As shown in **Figure 2****,** polishing pad **104** includes polishing layer **202** and may include in addition a subpad **250.** It is noted that subpad **250** is not required and polishing layer **202** may be secured directly, via base layer **240,** to a platen of a polisher, e.g., platen **130** of **Figure 1****.** Polishing layer **202** may be secured, via base layer **240,** to subpad **250** in any suitable manner, such as adhesive bonding, e.g., using a pressure sensitive adhesive layer **245** or hot-melt adhesive, heat bonding, chemical bonding, ultrasonic bonding, etc. The base layer **240** or subpad **250** may serve as the polishing base for attachment of the polishing elements **208.** Preferably, a base portion of polishing elements **208** extends into base layer 240.

Various methods of manufacture are possible for polishing texture **200.** For larger-scale networks, these include micromachining, laser or fluid-jet etching, and other methods of material removal from a starting solid mass; and focused laser polymerization, filament extrusion, fiber spinning, preferential optical curing, biological growth, and other methods of material construction within an initially empty volume. For smaller-scale networks, crystallization, seed polymerization, lithography or other techniques of preferential material deposition may be employed, as well as electrophoresis, phase nucleation, or other methods of establishing a template for subsequent material self-assembly.

The continuous non-fugitive phase **207** (i.e., polishing elements **204** and **208**) and base layer **240** of microstructure **200** may be made of any suitable material, such as polycarbonates, polysulfones, nylons, polyethers, polyesters, polystyrenes, acrylic polymers, polymethyl methacrylates, polyvinylchlorides, polyvinylfluorides, polyethylenes, polypropylenes, polybutadienes, polyethylene imines, polyurethanes, polyether sulfones, polyamides, polyether imides, polyketones, epoxies, silicones, copolymers thereof (such as, polyether-polyester copolymers), and mixtures thereof. Polishing elements **204** and **208** and base layer **240** may also be made of a non-polymeric material such as ceramic, glass, metal, stone, wood, or a solid phase of a simple material such as ice. Polishing elements **204** and **208** and base layer **240** may also be made of a composite of a polymer with one or more non-polymeric materials.

In general, the choice of material for the continuous non-fugitive phase **207,** the co-continuous fugitive phase **205** and base layer **240** is limited by its suitability for polishing an article made of a particular material in a desired manner. Similarly, subpad **250** may be made of any suitable material, such as the materials mentioned above for the continuous non-fugitive phase **207** and base layer **240.** Polishing pad **104** may optionally include a fastener for securing the pad to a platen, e.g., platen **130** of **Figure 1****,** of a polisher. The fastener may be, e.g., an adhesive layer, such as a pressure sensitive adhesive layer **245,** hot melt adhesive, a mechanical fastener, such as the hook or loop portion of a hook and loop fastener. It is also within the scope of the invention to implement one or more fiber-optic endpointing devices **270** or similar transmission devices that occupy one or more of the void spaces of polishing texture **200.**

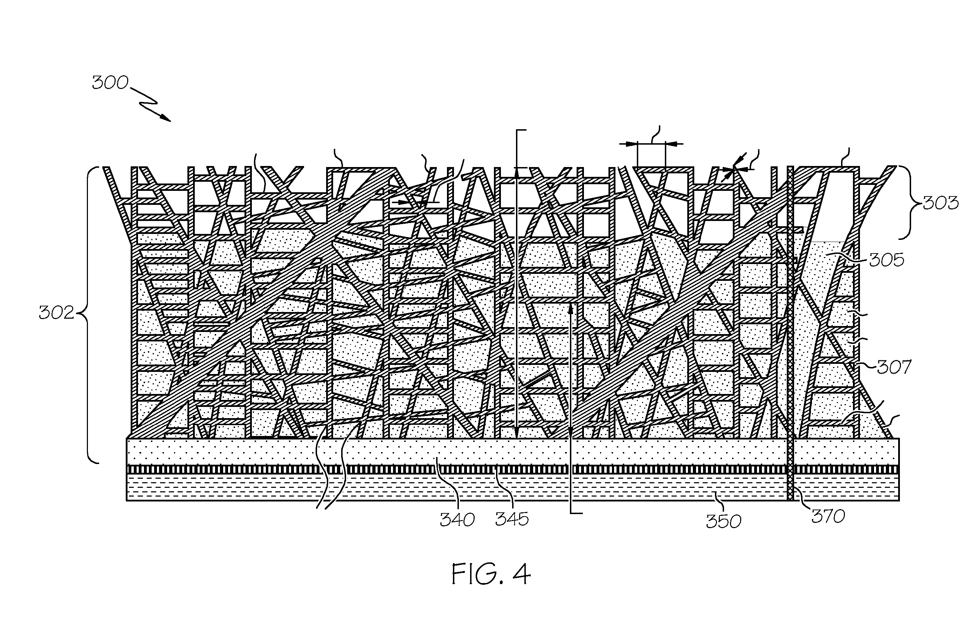

The polishing texture **300** of **Figure 4** illustrates that the present invention comprehends a continuous non-fugitive phase forming open interconnected networks comprising elements positioned at all angles from fully horizontal to fully vertical. By extension, the invention comprehends a continuous non-fugitive phase forming an entirely random array of slender elements in which there is no clearly repeating size or shape to the void spaces within the polishing texture that are not occupied by the continuous non-fugitive phase, or where many elements are highly curved, branched, or entangled. Familiar images that, as continuous non-fugitive phase microstructures, would fall within the scope of the invention are bridge trusses, stick models of macromolecules, and interconnected human nerve cells. In each case the structure must possess the same critical features, namely that sufficient interconnection in three dimensions is present to stiffen the overall network, that a wearing of the network in a horizontal plane from the top surface produces slender elements having locally unbuttressed ends that provide compliance with a workpiece over short length scales, and that the space not occupied by the continuous non-fugitive phase and length to width ratio of the elements conform to the geometric limits given previously. Further, **Figure 4** illustrates that the present invention comprehends a co-continuous fugitive phase that substantially fills the areas of the polishing texture **300** not occupied by the continuous non-fugitive phase and not within the hydrodynamic region.

With reference to **Figure 4****,** a second embodiment of polishing pad **104** of **Figure 1** consistent with the present invention is described with respect to an alternative surface polishing texture **300**-a side cross-sectional view of **Figure 4** would have a similar asymmetrical pattern of interconnected reticulated unit cells within polishing layer **302.** Similar to the pad of **Figure 2****,** adhesive layer **345** secures base layer **340** to optional subpad **350;** and optionally includes endpointing device **370.** Polishing texture **300** comprises a continuous non-fugitive phase **307** and a co-continuous fugitive phase **305.** The continuous non-fugitive phase **307** comprises elements **304** and **308.** Polishing texture **300** differs from polishing texture **200** of **Figure 2** in three aspects. First, the elements **308** of polishing texture **300** are not strictly vertical but are positioned at a variety of angles between 45 and 90 degrees with respect to the base layer **340** and the horizontal plane, and a few of the elements **308** are curved rather than straight. Also, the interconnecting elements **304** are not all horizontal but some are positioned at angles of 0 to 45 degrees with respect to the base layer **340** and the horizontal plane. As such, polishing texture **300** consists of unit cells, but the cells vary in shape and number of faces. These features notwithstanding, height **314** of elements **308** does not vary substantially within polishing texture **300** between the polishing layer or polishing element **306** and the half height **315** of the polishing texture **300.** Second, there is more variation in the width **310,** pitch **318,** and cross-sectional area **322** among elements **304** and **308** than in the corresponding attributes of polishing elements **208.** Third, the slurry flow through and among elements **304** and **308** in the hydrodynamic region **303** follows more irregular paths than the slurry flow through polishing elements **208** in the hydrodynamic region **203.** Nonetheless, polishing texture **300** embodies the essential properties of the present invention where elements **306** form the polishing surface. In particular, the elements **304** and **308** interconnect at junctions **309** to form a network interconnected in three dimensions to a sufficient degree to impart stiffness to the polishing texture as a whole, while the unbuttressed ends of elements **308** provide local flexibility to conform to a workpiece. In addition, the elements **304** and **308** are still sufficiently slender and widely spaced to allow a favorable balancing of contact area and flow area; the ratio of the mean pitch **318** of elements **308** to the mean width **310** of elements **308** is at least 2 and the ratio of the height **314** to the mean width **310** of the elements **308** is at least 4. As such, the contact area **322** of polishing texture **300** may reach 25% or greater and the open area **326,** while more irregular than flow area **226** of polishing texture **200,** is large enough to allow polish debris to be conveyed horizontally among the elements **304** and **308** in the hydrodynamic region **303** not occupied by co-continuous fugitive phase **305,** while still providing vertical distance between this conveyed debris and the wafer.

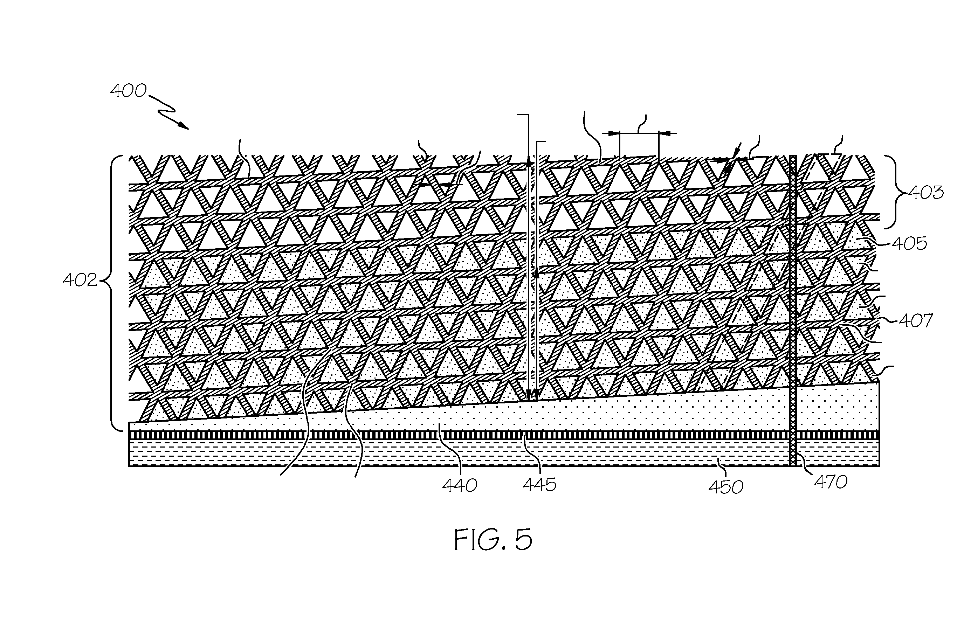

An additional embodiment of the invention is shown in **Figure 5** and consists of polishing layer **402** having a continuous non-fugitive phase **407** comprising a regular-spaced interconnected tetrahedral lattice of elements **404** and **408.** All elements **404** and **408** are shown as identical in length and width that join at junctions **409,** though this need not be so. In the embodiment shown, the unit cell is a regular tetrahedron in which each (of four) faces is an equilateral triangle, the side of which is the pitch **418** of the network, and solid members having a width **410** run along only the four edges of the spatial unit, leaving the center of each triangular face and of the spatial unit as a whole empty. Because of the symmetry of the tetrahedral lattice, a side cross-sectional and plan view of **Figure 5** would form the same reticulated pattern. This polishing texture provides the highest possible stiffness because triangularly faceted polyhedra are non-deformable. As the structure wears, free ends are formed on elements **408** that provide local deformability and compliance to the workpiece. In the embodiment shown in **Figure 5****,** the tetrahedral network is constructed on a slightly wedge-shaped base layer **440** so that no planes of the network are positioned exactly parallel to the plane of contact with the wafer. At a given point in time only a subset of members **406** are wearing along their longest dimension, while most of the area of contact is provided by the smaller cross sectional areas **422** of elements wearing across their shorter dimensions. This provides the feature that the contact area remains essentially invariant over the height **414** between the polishing layer or polishing element **406** and the half height **415** of the polishing texture **400.** Across the wedge-shaped base layer **440,** the mean area **426** for slurry flow in the hydrodynamic region **403** not occupied by co-continuous fugitive phase **405** may vary slightly. Although not depicted in the drawing, in some embodiments of the present invention, the co-continuous fugitive phase material could have a top surface that coincides with the polishing interface (e.g., when the co-continuous phase material melts upon exposure to heat present during polishing). To minimize this variation, in practice base layer **440** is stepped such that a repeating series of wedge-shaped sections supports the network. The structure shown in **Figure 5** is approximately one repeating unit. Similar to the pad of **Figure 2****,** adhesive layer **445** secures base layer **440** to optional subpad **450;** and optionally includes endpointing device **470.**

The invention provides the advantage of decoupling contact mechanics from fluid mechanics. In particular, it allows effective slurry flow within the hydrodynamic region of the polishing pad to easily remove polishing debris. In addition, it allows adjustment of the polishing elements' stiffness, height and pitch to control contact mechanics with a substrate. Furthermore, the polishing elements' shape allows the reduction or elimination of conditioning for increased polishing pad life. Finally, the uniform cross sectional area allows polishing of multiple substrates, such as patterned wafers with similar polishing characteristics.

In some embodiments of the present invention, the chemical mechanical polishing pad has a central axis and is adapted for rotation about the central axis. (See **Figure 6**). In some aspects of these embodiments, the polishing layer **510** of the chemical mechanical polishing pad is in a plane substantially perpendicular to the central axis **512.** In some aspects of these embodiments, the polishing layer **510** is adapted for rotation in a plane that is at an angle, θ, of 80 to 100° to the central axis **512.** In some aspects of these embodiments, the polishing layer **510** is adapted for rotation in a plane that is at an angle, θ, of 85 to 95° to the central axis **512.** In some aspects of these embodiments, the polishing layer **510** is adapted for rotation in a plane that is at an angle, θ, of 89 to 91° to the central axis **512.** In some aspects of these embodiments, the polishing layer **510** has a polishing surface **514** that has a substantially circular cross section perpendicular to the central axis **512.** In some aspects of these embodiments, the radius, r, of the cross section of the polishing surface **514** perpendicular to the central axis **512** varies by ≤ 20% for the cross section. In some aspects of these embodiments, the radius, r, of the cross section of the polishing surface **514** perpendicular to the central axis **512** varies by ≤ 10% for the cross section.

In **Figure 6** there is provided a side perspective view of a chemical mechanical polishing pad of one embodiment of the present invention. In particular, **Figure 6** depicts a single layer chemical mechanical polishing pad **510.** The chemical mechanical polishing pad **510** has a polishing surface **514** and a central axis **512.** The polishing surface **514** has a substantially circular cross section with a radius **r** from the central axis **512** to the outer periphery of the polishing surface **515** in a plane at an angle 0 to the central axis **512.**

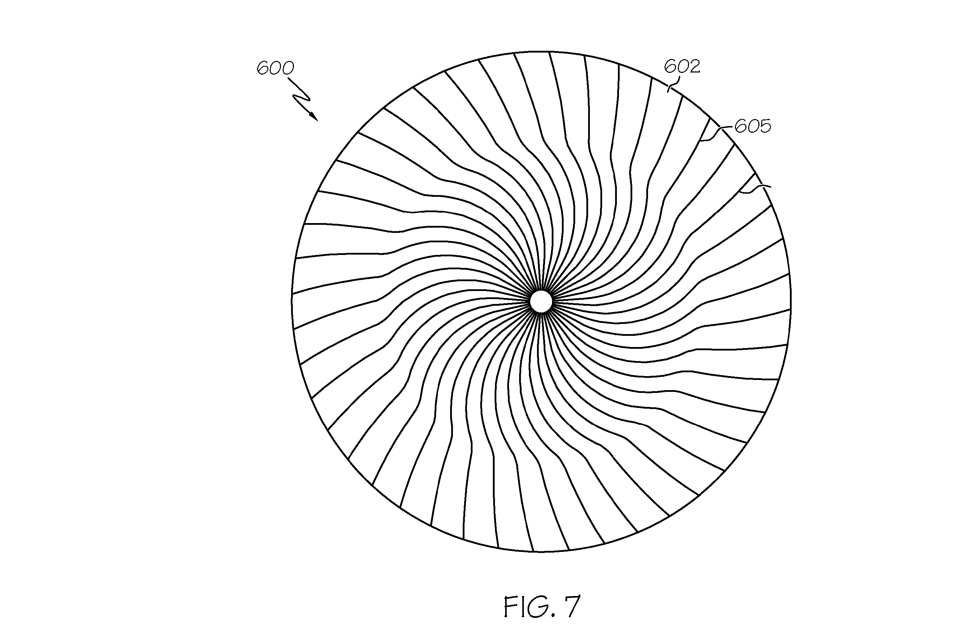

In **Figure 7** there is provided a top plan view of a chemical mechanical polishing pad of one embodiment of the present invention. In particular, **Figure 7** depicts a chemical mechanical polishing pad **600** having a polishing surface **602** with a groove pattern of a plurality of curved grooves **605.**

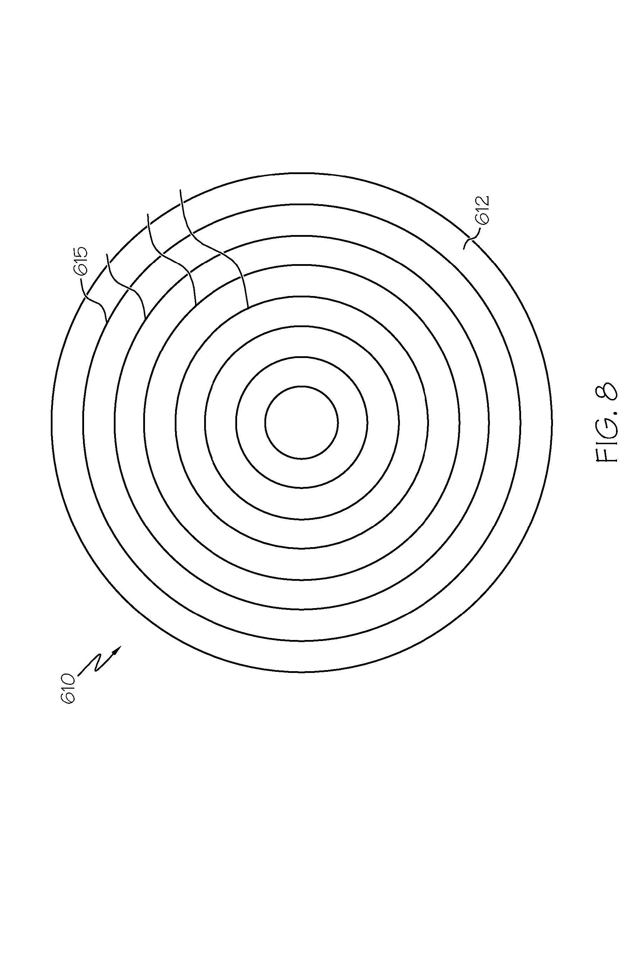

In **Figure 8** there is provided a top plan view of a chemical mechanical polishing pad of one embodiment of the present invention. In particular, **Figure 8** depicts a chemical mechanical polishing pad **610** having a polishing surface **612** with a groove pattern of a plurality of concentric circular grooves **615.**

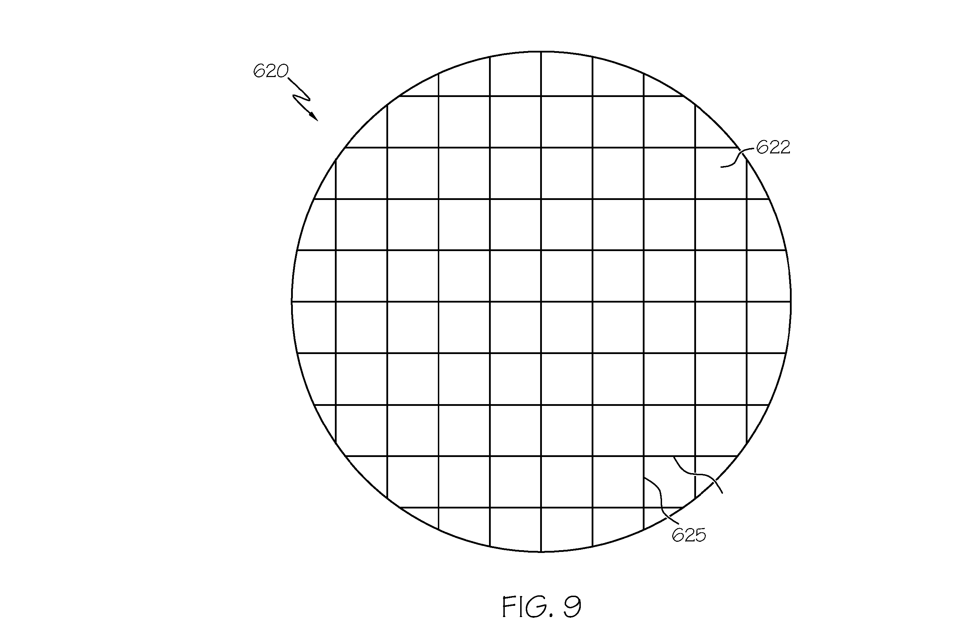

In **Figure 9** there is provided a top plan view of a chemical mechanical polishing pad of one embodiment of the present invention. In particular, **Figure 9** depicts a chemical mechanical polishing pad **620** having a polishing surface **622** with a groove pattern of a plurality of linear grooves **625** in an X-Y grid pattern.

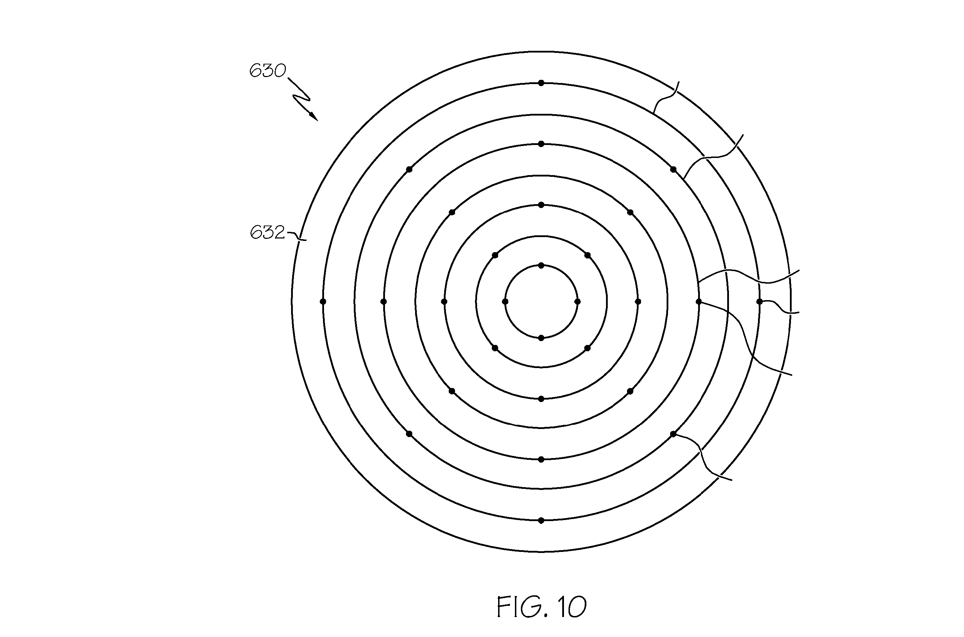

In **Figure 10** there is provided a top plan view of a chemical mechanical polishing pad of one embodiment of the present invention. In particular, **Figure 10** depicts a chemical mechanical polishing pad **630** having a polishing surface **632** with a combination of a plurality of perforations **638** and a plurality of concentric circular grooves **635.**

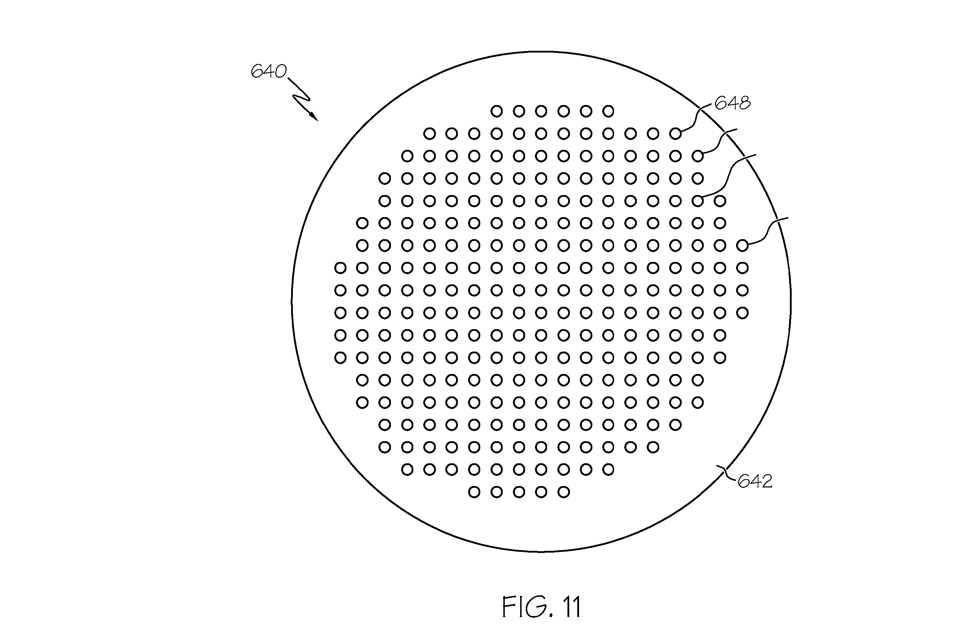

In **Figure 11** there is provided a top plan view of a chemical mechanical polishing pad of one embodiment of the present invention. In particular, **Figure 11** depicts a chemical mechanical polishing pad **640** having a polishing surface **642** with a plurality of perforations **648.**

## Claims

1. A chemical mechanical polishing pad (104) for polishing a substrate selected from at least one of a magnetic substrate, an optical substrate and a semiconductor substrate (112) ; comprising:
a polishing layer (202) comprising an interpenetrating network,
wherein the interpenetrating network comprises a continuous non-fugitive phase (207) and a substantially co-continuous fugitive phase (205) ; and wherein the polishing layer has a polishing surface adapted for polishing the substrate,
**characterized in that** said co-continuous fugitive phase melts upon exposure to heat generated during polishing.

2. The chemical mechanical polishing pad of claim 1, wherein the chemical mechanical polishing pad comprises a hydrodynamic region (203) proximate to the polishing surface, wherein the hydrodynamic region is substantially free of the fugitive phase.

3. The chemical mechanical polishing pad of claim 2, wherein the hydrodynamic region extends from the polishing surface into the chemical mechanical polishing pad to a depth of 1 to 100 microns.

4. The chemical mechanical polishing pad of claim 1, wherein the continuous non-fugitive phase forms a reticulated network.

5. The chemical mechanical polishing pad of claim 1, wherein the continuous non-fugitive phase has a fibrillar morphology.

6. The chemical mechanical polishing pad of claim 1, wherein the polishing layer comprises 0.5 to 80 vol% of the continuous non-fugitive phase.

7. The chemical mechanical polishing pad of claim 1, wherein the continuous non-fugitive phase is non-water soluble and the co-continuous fugitive phase is water soluble.

8. The chemical mechanical polishing pad of claim 1, wherein the non-fugitive phase forms a three-dimensional network that comprises a plurality of interconnected polishing elements (204, 208) that define a reticulated interstitial area; and wherein the substantially co-continuous fugitive phase is disposed within the reticulated interstitial area.

9. A method for polishing a substrate, comprising:
providing a substrate selected from at least one of a magnetic substrate, an optical substrate and a semiconductor substrate (112);
providing a chemical mechanical polishing pad (104) according to claim 1;
providing a polishing medium at an interface between the polishing surface (110) and the substrate; and,
creating dynamic contact at the interface between the chemical mechanical polishing pad and the substrate.

## Patentansprüche

1. Eine Scheibe für chemisch-mechanisches Polieren (104) zum Polieren eines Substrats, das aus mindestens einem von einem magnetischen Substrat, einem optischen Substrat und einem Halbleitersubstrat (112) ausgewählt ist; beinhaltend:
eine Polierschicht (202), die ein durchdringendes Netzwerk beinhaltet,
wobei das durchdringende Netzwerk eine kontinuierliche nichtflüchtige Phase (207) und eine im Wesentlichen co-kontinuierliche flüchtige Phase (205) beinhaltet; und wobei die Polierschicht eine Polieroberfläche aufweist, die zum Polieren des Substrats angepasst ist,
**dadurch gekennzeichnet, dass** die co-kontinuierliche flüchtige Phase bei Exposition gegenüber während des Polierens erzeugter Wärme schmilzt.

2. Scheibe für chemisch-mechanisches Polieren gemäß Anspruch 1, wobei die Scheibe für chemisch-mechanisches Polieren eine hydrodynamische Region (203) nahe der Polieroberfläche beinhaltet, wobei die hydrodynamische Region im Wesentlichen frei von der flüchtigen Phase ist.

3. Scheibe für chemisch-mechanisches Polieren gemäß Anspruch 2, wobei sich die hydrodynamische Region von der Polieroberfläche zu einer Tiefe von 1 bis 100 Mikrometern in die Scheibe für chemisch-mechanisches Polieren erstreckt.

4. Scheibe für chemisch-mechanisches Polieren gemäß Anspruch 1, wobei die kontinuierliche nichtflüchtige Phase ein retikulares Netzwerk bildet.

5. Scheibe für chemisch-mechanisches Polieren gemäß Anspruch 1, wobei die kontinuierliche nichtflüchtige Phase eine fibrilläre Morphologie aufweist.

6. Scheibe für chemisch-mechanisches Polieren gemäß Anspruch 1, wobei die Polierschicht zu 0,5 bis 80 Vol.-% die kontinuierliche nichtflüchtige Phase beinhaltet.

7. Scheibe für chemisch-mechanisches Polieren gemäß Anspruch 1, wobei die kontinuierliche nichtflüchtige Phase nicht wasserlöslich ist und die co-kontinuierliche flüchtige Phase wasserlöslich ist.

8. Scheibe für chemisch-mechanisches Polieren gemäß Anspruch 1, wobei die nichtflüchtige Phase ein dreidimensionales Netzwerk bildet, das eine Vielzahl von untereinander verbundenen Polierelementen (204, 208) beinhaltet, die einen retikularen interstitiellen Bereich definieren; und wobei die im Wesentlichen co-kontinuierliche flüchtige Phase innerhalb des retikularen interstitiellen Bereichs angeordnet ist.

9. Ein Verfahren zum Polieren eines Substrats, beinhaltend:
Bereitstellen eines Substrats, das aus mindestens einem von einem magnetischen Substrat, einem optischen Substrat und einem Halbleitersubstrat (112) ausgewählt ist; Bereitstellen einer Scheibe für chemisch-mechanisches Polieren (104) gemäß Anspruch 1;
Bereitstellen eines Poliermediums an einer Berührungsfläche zwischen der Polieroberfläche (110) und dem Substrat; und
Erzeugen eines dynamischen Kontaktes an der Berührungsfläche zwischen der Scheibe für chemisch-mechanisches Polieren und dem Substrat.

## Revendications

1. Un tampon de polissage chimico-mécanique (104) pour polir un substrat sélectionné parmi au moins soit un substrat magnétique, soit un substrat optique, soit un substrat semiconducteur (112) ; comprenant :
une couche de polissage (202) comprenant un réseau interpénétré,
dans lequel le réseau interpénétré comprend une phase continue non fugitive (207) et une phase substantiellement co-continue fugitive (205) ; et dans lequel la couche de polissage présente une surface de polissage conçue pour polir le substrat,
**caractérisé en ce que** ladite phase co-continue fugitive fond dès exposition à de la chaleur générée au cours du polissage.

2. Le tampon de polissage chimico-mécanique de la revendication 1, le tampon de polissage chimico-mécanique comprenant une région hydrodynamique (203) à proximité de la surface de polissage, la région hydrodynamique étant substantiellement exempte de la phase fugitive.

3. Le tampon de polissage chimico-mécanique de la revendication 2, dans lequel la région hydrodynamique s'étend depuis la surface de polissage dans le tampon de polissage chimico-mécanique jusqu'à une profondeur de 1 à 100 microns.

4. Le tampon de polissage chimico-mécanique de la revendication 1, dans lequel la phase continue non fugitive forme un réseau réticulé.

5. Le tampon de polissage chimico-mécanique de la revendication 1, dans lequel la phase continue non fugitive présente une morphologie fibrillaire.

6. Le tampon de polissage chimico-mécanique de la revendication 1, dans lequel la couche de polissage comprend de 0,5 à 80 % en volume de la phase continue non fugitive.

7. Le tampon de polissage chimico-mécanique de la revendication 1, dans lequel la phase continue non fugitive est non soluble dans l'eau et la phase co-continue fugitive est soluble dans l'eau.

8. Le tampon de polissage chimico-mécanique de la revendication 1, dans lequel la phase non fugitive forme un réseau tridimensionnel qui comprend une pluralité d'éléments de polissage interconnectés (204, 208) qui définissent une aire interstitielle réticulée ; et dans lequel la phase substantiellement co-continue fugitive est disposée au sein de l'aire interstitielle réticulée.

9. Une méthode pour polir un substrat, comprenant:
le fait de fournir un substrat sélectionné parmi au moins soit un substrat magnétique, soit un substrat optique, soit un substrat semiconducteur (112) ;
le fait de fournir un tampon de polissage chimico-mécanique (104) selon la revendication 1 ;
le fait de fournir un milieu de polissage au niveau d'une interface entre la surface de polissage (110) et le substrat ; et
le fait de créer un contact dynamique au niveau de l'interface entre le tampon de polissage chimico-mécanique et le substrat.
